# EUROPÄISCHE PATENTANMELDUNG

(11) **EP 1 727 208 A1**
(43) Veröffentlichungstag der Anmeldung: **29.11.2006**
(21) Anmeldenummer: 06009195.6
(22) Anmeldetag: 04.05.2006
(51) Int. Cl.: H01L 29/73, H01L 29/08

(54) **Integrierter Schaltkreis und Verfahren zur Herstellung eines integrierten Schaltkreises**

(30) Priorität: 10.05.2005 DE 102005021450
(71) Anmelder: ATMEL Germany GmbH, 74072 Heilbronn (DE)
(72) Erfinder: Tolonics, Johann, Dr. Dipl.-Ing., 74081 Heilbronn (DE); Locke, Klaus, Dr., 73249 Wernau (DE); Brandl, Peter, Dipl.-Ing., 9500 Villach (AT)

(57) **Zusammenfassung**

Integrierter Schaltkreis mit
- einem vertikal integrierten Bipolartransistor und
- zumindest einem Emitterwiderstand, der mit einem Emitterhalbleitergebiet (300) des vertikal integrierten Bipolartransistors leitend verbunden ist,
wobei
- zumindest bereichsweise ein Kollektorhalbleitergebiet (50), ein Basishalbleitergebiet (400) und das Emitterhalbleitergebiet (300) vertikal übereinander angeordnet und monokristallin ausgebildet sind,
- ein Widerstandsgebiet (200) des Emitterwiderstandes über dem Emitterhalbleitergebiet (300) angeordnet und monokristallin ausgebildet ist, und
- das Widerstandsgebiet (200) zumindest bereichsweise einen größeren Schichtwiderstand als das Emitterhalbleitergebiet (300) aufweist.

## Beschreibung

Die vorliegende Erfindung betrifft einen integrierten Schaltkreis und ein Verfahren zur Herstellung eines integrierten Schaltkreises.

Aus dem Stand der Technik ist bekannt, den Emitter eines Bipolartransistors mit einem Widerstand zu verbinden, um eine Stromgegenkopplung zu erreichen. Hierzu weist der Emitter des Bipolartransistors beispielsweise eine Silizidschicht auf, die beispielsweise über Metallbahnen einer Verdrahtungsebene leitend mit dem Widerstand verbunden sind.

Aus der US 6,177,717 B1 ist ein derartiger Bipolartransistor bekannt. Zur Herstellung wird ein intrinsischer Kollektor eines vertikalen Bipolartransistors epitaktisch auf einer extrinsischen, im Halbleitersubstrat vergrabenen Kollektorschicht aufgewachsen. Ein lateraler Isolator umgibt den oberen Teil des intrinsischen Kollektors. Eine Silizium-Germanium-Basis oberhalb des intrinsischen Kollektors und oberhalb des lateralen Isolators wird mittels differentieller Epitaxie hergestellt. Ein in-situ dotierter Emitter wird innerhalb eines Fensters oberhalb der Basis epitaktisch derart aufgebracht, dass die Emitterregion als monokristallines Silizium in direktem Kontakt mit der Basis aus Silizium aufwächst.

Mittels der in-situ Dotierung des aufwachsenden Emitters wird erreicht, dass eine höhere Dotierstoffkonzentration im unteren Bereich in Kontakt mit der Basis als im oberen Bereich des Emitters eingebracht wird. Dies ermöglicht eine gute Silizidierung der oberen Oberfläche des monokristallinen Emitters. Mit der Variation des Dotierstoffgases wird eine Dotierstoffkonzentration von 3x10²⁰/cm³ in dem unteren Bereich und 10²⁰/cm³ im oberen Bereich des Emitters erzielt. Zusammen mit der Silizidierung (TiSi₂) kann ein deutlich niedrigerer Emitterwiderstand im Vergleich mit Transistoren mit polykristallinen Emittern ,erzielt werden.

Der Erfindung liegt die Aufgabe zu Grunde, einen integrierten Schaltkreis mit einem Bipolartransistor weiter zu entwickeln. Diese Aufgabe wird durch die Merkmale der unabhängigen Ansprüche gelöst. Vorteilhafte Weiterbildungen der Erfindung sind Gegenstand von abhängigen Ansprüchen.

Demgemäß ist ein integrierter Schaltkreis vorgesehen, der einen vertikal integrierten Bipolartransistor und zumindest einem Emitterwiderstand, der mit einem Emitterhalbleitergebiet des vertikal integrierten Bipolartransistors leitend verbunden ist, aufweist. Der Emitterwiderstand ist dabei durch die leitende Verbindung zum Emitter des Bipolartransistors abschließend definiert. Bevorzugt dient der Emitterwiderstand in dem integrierten Schaltkreis als Stromgegenkopplung, wenn der Bipolartransistor als Verstärkerelement beschaltet ist.

Erfindungsgemäß sind zumindest bereichsweise ein Kollektorhalbleitergebiet, ein Basishalbleitergebiet und das Emitterhalbleitergebiet vertikal übereinander angeordnet und monokristallin ausgebildet. Bevorzugt weisen diese Halbleitergebiete ein Siliziumkristall oder ein Silizium-Germanium-Mischkristall auf, die entsprechend eines npn-Transistors oder eine pnp-Transistors n-leitend beziehungsweise p-leitend dotiert sind.

Ein Widerstandsgebiet des Emitterwiderstandes ist über dem Emitterhalbleitergebiet angeordnet und monokristallin ausgebildet. Vorteilhafterweise ist das monokristalline Widerstandsgebiet ein Siliziumkristallgitter mit Dotierstoffen, die die Leitfähigkeit des Emitterwiderstandes beeinflussen.

Alternativ oder in Kombination kann das monokristalline Widerstandsgebiet auch einen Mischkristall aufweisen, der neben Silizium beispielsweise Germanium oder Kohlenstoff aufweist. Vorzugsweise setzt das Kristallgitter des Emitterwiderstands das Kristallgitter des Emitterhalbleitergebietes fort.

Erfindungsgemäß weist das Widerstandsgebiet zumindest bereichsweise einen um zumindest den Faktor 10 größeren Schichtwiderstand als das Emitterhalbleitergebiet auf. Das Widerstandsgebiet mit dem Bereich mit dem größeren Schichtwiderstand ist von dem Emitterhalbleitergebiet vorzugsweise distanziert ausgebildet. Vorteilhafterweise ist zudem das Widerstandsgebiet mit dem Bereich zu einem Anschlussgebiet des Emitterwiderstands vorzugsweise angrenzend ausgebildet. Das Anschlussgebiet weist vorteilhafterweise eine Silizidschicht oder eine hochdotierte Schicht für einen niederohmigen Anschlusswiderstand auf, so dass dieser keinen signifikanten Einfluss auf den Emitterwiderstandswert ausübt. Weiterhin ist der Bereich des Widerstandsgebiets von dem Emitterhalbleitergebiet vorzugsweise derart distanziert, dass eine Raumladungszone der Basis-Emitter-Diode vorteilhafterweise für alle Betriebbedingungen nicht in den Bereich des Widerstandgebiets hineinragt.

Eine vorteilhafte Weiterbildung der Erfindung sieht vor, dass der Emitterwiderstand ein Dotierstoffkonzentrationsprofil aufweist, dass einen niederohmigen Anschluss des Widerstandsgebiets an das Emitterhalbleitergebiet bewirkt. Vorzugsweise bewirkt das Profil zudem einen niederohmigen Anschluss an zumindest ein weiteres Bauelement und/oder einen Anschluss des integrierten Schaltkreises.

Zwei Vorzugsvarianten der Erfindung sehen vor, dass ein Gebiet des Emitterwiderstandes, insbesondere das Widerstandgebiet ein Siliziumkristall mit Kohlenstoff und/oder Germanium aufweist. Der Kohlenstoff und das Germanium können dabei beispielsweise in das Siliziumkristallgitter eingebaut sein und dessen Widerstandswert lokal verändern.

In einer bevorzugten Ausgestaltung der Erfindung ist vorgesehen, dass das Widerstandgebiet eine Dotierstoffkonzentration aufweist, die kleiner als ein Zehntel der Dotierstoffkonzentration im Emitterhalbleitergebiet ist. So kann durch geringere Dotierstoffkonzentration der Leitwert bereichsweise reduziert sein, so dass beispielsweise der vertikale Widerstandsbereich von der Waferoberfläche in Richtung der Wafertiefe einen beispielsweise linear oder logarithmisch zunehmenden oder abnehmenden Widerstandswert aufweist.

Bevorzugt ist vorgesehen, dass der Bipolartransistor und der Emitterwiderstand Bestandteil einer Hochfrequenzschaltung, insbesondere eines Hochfrequenzverstärkers sind, wobei der Emitterwiderstand als Stromgegenkopplung verschaltet ist.

Die Erfindung vorteilhaft weiterbildend ist zumindest ein weiterer Bipolartransistor vorgesehen, dem zumindest ein weiterer Emitterwiderstand zugeordnet ist. Dabei unterscheidet sich der Schichtwiderstand des weiteren Emitterwiderstands von dem anderen Schichtwiderstand signifikant, wobei die zumindest zwei Emitterwiderstände auf einem Wafer prozessiert werden und der unterschiedliche Schichtwiderstand durch eine Maskierung erzeugt ist.

Bevorzugt liegt eine Widerstandsgrundfläche des Emitterwiderstands innerhalb einer Transistorgrundfläche des Bipolartransistors. Dabei können eine Vielzahl von Emitterfingern des Bipolartransistors vorgesehen sein, wobei mit jedem Emitterfinger ein oder mehrere Emitterwiderstände leitend verbunden sind.

Ein anderer Aspekt der Erfindung ist eine Verwendung eines zuvor beschriebenen integrierten Schaltkreises in einer Hochfrequenzvorrichtung, insbesondere in einem Radarsystem oder in einem Kommunikationssystem, beispielsweise in der Automobiltechnik.

Ein weiterer Aspekt der Erfindung ist ein Verfahren zur Herstellung eines integrierten Schaltkreises. In diesem Verfahren wird ein vertikal integrierter Bipolartransistor und zumindest ein Emitterwiderstand erzeugt, wobei der Emitterwiderstand mit einem Emitterhalbleitergebiet des vertikal integrierten Bipolartransistors leitend verbunden wird.

Zur Erzeugung des Emitterwiderstands wird ein Widerstandsgebiet über dem Emitterhalbleitergebiet monokristallin aufgebracht, indem Halbleitermaterial des Widerstandsgebiets selektiv über das Emitterhalbleitergebiet abgeschieden wird. Dabei wird das Widerstandsgebiet derart epitaktisch aufgebracht, dass der Schichtwiderstand des Widerstandsgebiets größer ist als der Schichtwiderstand des Emitterhalbleitergebiets. Vorzugsweise ist der Schichtwiderstand des Widerstandsgebiets zumindest um den Faktor 10 größer als der Schichtwiderstand des Emitterhalbleitergebiets Zwischen dem Widerstandsgebiet und dem Emitterhalbleitergebiet kann zudem ein hochdotiertes Verbindungsgebiet aufgebracht werden.

Eine bevorzugte Weiterbildung dieses Aspekts der Erfindung sieht vor, dass das Widerstandgebiet während der Epitaxie in situ mit einer um zumindest den Faktor 10 kleineren Dotierstoffkonzentration zumindest bereichsweise dotiert wird.

Alternative, auch kombinierbare Verfahrensvarianten der Erfindung ermöglichen durch die Zugabe von GeH₄-Gas während der Epitaxie, dass Germaniumatome in das Widerstandsgebiet eingebracht werden. Beziehungsweise wird durch die Zugabe von Methylsilan-Gas während der Epitaxie ermöglicht, dass Kohlenstoffatome in das Widerstandsgebiet eingebracht werden.

Im Folgenden wird die Erfindung in Ausführungsbeispielen anhand von Figuren näher erläutert.

Dabei zeigen
- Fig. 1: eine schematische Schnittansicht durch einen Wafer mit einem vertikal integrierten Bipolartransistor und einem vertikal integrierten Emitterwiderstand, und
- Fig. 2: einen schematischen Dotierstoffkonzentrationsverlauf entlang der Linie A-A.

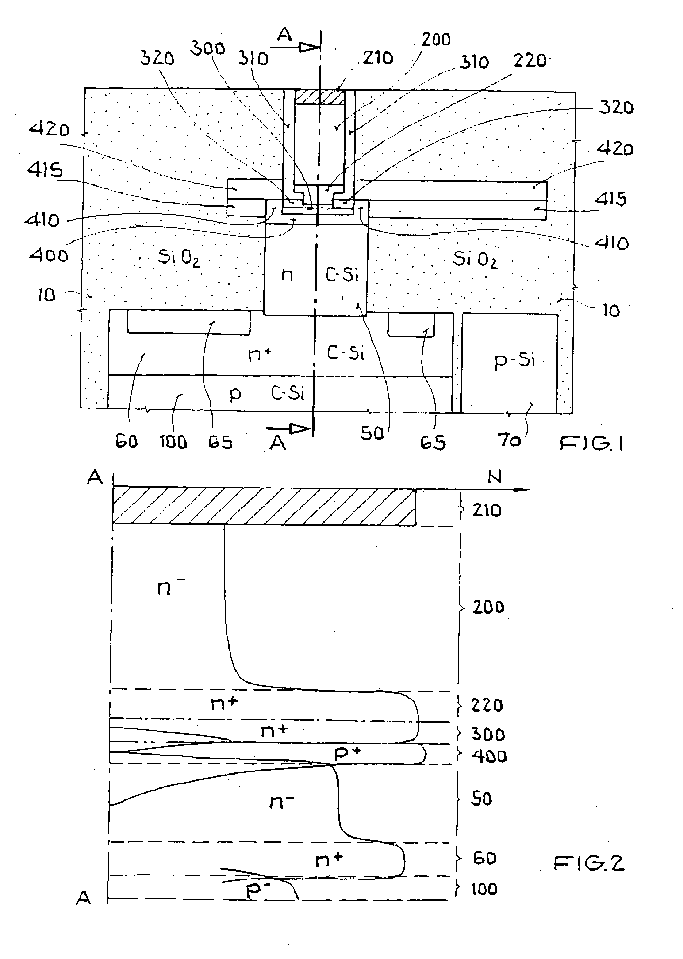

In Fig. 1 ist ein Ausführungsbeispiel für einen Heterobipolartransistor und einen Emitterwiderstand eines integrierten Schaltkreises als Schnittansicht durch einen prozessierten Wafer dargestellt.

Es ist ein Teil eines monokristallinen, p-dotierten Siliziumsubstrats 100 dargestellt, in dem eine hochdotierte, vergrabene Schicht 60 des n-Leitungstyps erzeugt ist. Auf einem ersten Bereich der vergrabenen Schicht 60 wird in folgenden Prozessschritten ein Heterobipolartransistor erzeugt. Zur Isolierung dieses Heterobipolartransistors von weiteren Transistoren oder anderen Bauelementen sind Grabenisolationen vorgesehen, die mit polykristallinem Silizium 70 oder TEOS-Oxid gefüllt sind. Um die vergrabene Schicht 60 anzuschließen, ist eine vergrabene Silizidschicht 65 aus TiSi₂ vorgesehen.

Auf der vergrabenen Schicht 60 ist ein monokristallines Kollektorhalbleitergebiet 50 epitaktisch aufgebracht, das eine geringere Dotierstoffkonzentration aufweist als die vergrabene Schicht 60. Das Kollektorhalbleitergebiet 50 ist lateral durch ein Dielektrikum 10 aus Siliziumdioxid von anderen Schichten und Bauelementen isoliert.

Ebenfalls isoliert das Dielektrikum 10 ein p-dotiertes Basishalbleitergebiet 400, 410, 415. Die Bereiche 400 und 410 des Basishalbleitergebiets grenzen an das Kollektorhalbleitergebiet 50 und sind ebenfalls monokristallin ausgebildet, während das Gebiet einer äußeren Basis 415 auf dem Dielektrikum 10 polykristallin aufwächst. Das Basishalbleitergebiet 400, 410, 415 wird differentiell aufgebracht und kann einen Silizium-Germanium-Mischkristall zur Ausbildung eines Heteroübergangs aufweisen. Um die äußere Basis möglichst niederohmig anzuschließen, grenzt an das Basishalbleitergebiet im Bereich der äußeren Basis eine Silizidschicht aus TiSi₂ an. Die metallischen Verdrahtungen der Silizidschichten 420, 65 der äußeren Basis und der vergrabenen Schicht sind in Fig. 1 zur vereinfachten Darstellung fortgelassen.

An das Basishalbleitergebiet 400 der inneren Basis grenzt das n-dotierte Emitterhalbleitergebiet 300. An das Emitterhalbleitergebiet 300 grenzt innerhalb zweier Dielektrika 310, 320 ein Emitterwiderstand, der drei Gebiete 220, 200 und 210 aufweist. Die Ausbildung des Emitterwiderstands erfolgt, indem lediglich innerhalb des durch die Dielektrika 310, 320 gebildeten Emitterfensters selektiv monokristallines Silizium oder eine monokristalline Silizium-Germanium-Schicht epitaktisch aufgewachsen wird. Außerhalb des Fensters erfolgt über Siliziumoxid- oder Siliziumnitridgebieten 10 keine Abscheidung. Ausgangspunkt ist für dieses Ausführungsbeispiel daher ein geöffnetes Emitterfenster des npn-Transistors, wobei die restlichen Bereiche zumindest des npn-Transistors mit einer Oxid- oder Nitridschicht 10 bedeckt sind.

Es wird zunächst der Wafer mit Flusssäure-haltiger Reinigungslösung und anschließender Trocknung mit Isopropanol der Wafer vorgereinigt. Anschließend erfolgt die Waferbeladung, des Epitaxie-Reaktors, wobei ein mehrfacher Stickstoff-Spülung und Evakuierung - Zyklus zur Verringerung von Oberflächenkontaminationen erfolgt.

Danach erfolgt eine Wasserstoff-Temperung bei 750°C bis 900°C, wobei das restliche native Oxid in dem Emitterfenster beseitigt wird und eine Desorption von Kohlenwasserstoffen erfolgt. Die Wasserstoff-Temperung im Epitaxiereaktor erzeugt eine kristallografisch saubere Silizium-Oberfläche. Beim Betrieb des npn-Transistors ist eine Injektion von Minoritäts-Ladungsträgern in den Emitter reduziert, da keine störende Grenzschicht zum Emitterwiderstand vorhanden ist. Damit wird eine signifikante Verbesserung der Stabilität der elektrischen Parameter des Schaltkreises ermöglicht.

Wiederum nachfolgend erfolgt eine selektive, insitu-dotierte epitaktische Abscheidung von Silizium oder Silizium und Germanium, die zunächst eine monokristalline Schicht 220 mit einer hohen Dotierung ausbilden. Diese Schicht ist ein Verbindungsgebiet 220 zwischen dem Widerstandsgebiet 200 und dem Emitterhalbleitergebiet 300. Vorzugsweise wird ohne Unterbrechung des Epitaxieprozesses ein Widerstandsgebiet 200 des Emitterwiderstands ebenfalls epitaktisch aufgebracht, so dass das Widerstandsgebiet 200 als monokristalline, Silizium aufweisende Struktur ausgebildet ist.

Die Einstellung des Emitterwiderstands erfolgt über die Dicke der Epitaxieschicht und/oder durch die Konzentration beziehungsweise den Konzentrationsverlauf der Dotierung dieses Widerstandsgebiets 200. Beispielsweise durch einen variablen Dotiergasfluss ist die Einstellung eines retrograden Dotierstoffprofils möglich. Durch die Zugabe von GeH₄-Gas kann eine definierte Menge an Germanium in das Silizium-Kristallgitter eingebaut werden. In den Gebieten 210, 220 des Emitterwiderstands kann der Einbau von Germanium dazu genutzt werden, die Löslichkeits- und Aktivierungsgrenze für Dotierstoffe zu erhöhen, so dass der Widerstand der epitaktischen Schicht in diesen Bereichen reduziert ist. Um den Übergangswiderstand zu reduzieren ist im Verbindungsgebiet 220 durch Zugabe von Germanium eine signifikante Erhöhung der Dotierstoffkonzentration möglich.

Durch Zugabe von Methylsilan-Gas kann Kohlenstoff in das Silizium-Kristallgitter des Widerstandsgebiets 200 eingebaut werden, um die elektrischen Eigenschaften der Bipolartransistor-Emitterwiderstands-Anordnung zu verändern. Der Widerstandswert kann daher eingestellt werden, ohne dass Änderungen des Layouts und Lithographiemasken erforderlich sind. Damit ergibt dieses Ausführungsbeispiel eine höhere Flexibilität für das Schaltungsdesign mit bipolaren Leistungs-Transistoren.

Das Widerstandsgebiet 200 ist in dem Ausführungsbeispiel der Fig. 1 durch eine Silizidschicht 210, die TiSi₂ aufweist, für einen niederohmigen Kontaktwiderstand angeschlossen. Alternativ kann eine hochdotierte monokristalline oder amorphe Halbleiterschlicht zum niederohmigen Anschluss dienen.

Dieses Ausführungsbeispiel ermöglicht eine Einsparung von Chip-Fläche sowie eine Verringerung des Designaufwands für das Layout durch die Integration eines Vertikalwiderstands als Emitterwiderstand in die Emitterstruktur des Bipolartransistors. Durch die Verringerung der Emitter-Arrayfläche ergeben sich kleinere parasitäre Kapazitäten und damit sind höhere Grenzfrequenzen, insbesondere für Leistungs-Hetero-Bipolartransistoren möglich.

In Fig. 2 ist schematisch die Dotierstoffverteilung entlang der in Fig. 1 eingezeichneten Linie A-A dargestellt. Dabei bildet die Halbleiterschicht 50 den n⁻-dotierten Kollektor mit einem n⁺-hochdotierten Subkollektor 60. Das Basishalbleifergebiet 400 der inneren Basis ist p⁺-hochdotiert. An das Basishalbleitergebiet 400 grenzt das Silizium-Halbleitergebiet 300 des Emitters, das ebenfalls n⁺-dotiert ist. Um einen rückwirkenden Einfluss des Emitterwiderstands auf das Emitterhalbleitergebiet 300 zu minimieren, weist der Emitterwiderstand eine an das Emitterhalbleitergebiet 300 angrenzendes Verbindungsgebiet 220 auf, das ebenfalls n⁺-dotiert ist. Insbesondere ist keine Grenzschicht zwischen dem Emitterhalbleitergebiet 300 und dem Verbindungsgebiet 220 vorhanden, welche die Ladungsträger-Bewegung beeinflussen könnte.

An das Verbindungsgebiet 220 grenzt ein Widerstandsgebiet 200 des Emitterwiderstandes, der eine geringe n⁻ Dotierung aufweist, die den Widerstandswert des Widerstandsgebiets 200 beeinflusst oder vollständig bestimmt. Weiterhin weist der Emitterwiderstand eine Anschlussschicht 210 auf, die in dem in Fig. 2 dargestellten Ausführungsbeispiel eine Silizidschicht ist. Eine derartige Anschlussschicht 210 ermöglicht die Verbindung des Emitterwiderstands mit einem anderen Bauteil oder einem Anschluss des integrierten Schaltkreises. Alternativ kann die Anschlussschicht 210 hoch n⁺⁻dotiert sein, um einen niedrigen Anschlusswiderstand zu erzielen.

Da der Emitterwiderstand unmittelbar an den Emitter grenzt, ist zudem eine direkte thermische Kopplung möglich, die gegenüber einer indirekten thermischen Kopplung über eine Metallisierungsstruktur wesentlich verbessert ist. Eine lokale Erhitzung eines Emitterfingers führt demzufolge zu einer direkten Erhitzung des angrenzenden Widerstandsgebiets 200, wodurch die Leitfähigkeit des Widerstandsgebiets 200 reduziert wird. Die Reduktion der Leitfähigkeit führt zu einer zunehmenden Stromgegenkopplung, so dass der lokale Stromfluss im erhitzten Emitterfinger reduziert wird.

Durch die Bipolartransistor-Emitterwiderstands-Struktur dieses Ausführungsbeispiels ist eine gleichmäßige Stromverteilung innerhalb des Emitterfinger-Arrays sichergestellt, so dass die Ausfallrate des integrierten Schaltkreises reduziert werden kann.

Die Einstellung des Emitterwiderstands erfolgt über technologische Parameter, wie die Dicke des epitaktisch gewachsenen Widerstandsgebiet 200, das Dotierstoffkonzentrationsprofil oder die Konzentration von Fremdelementen im Widerstandsgebiet 200. Der Widerstandswert des Widerstandsgebiet 200 kann über die Layout-Geometrie des Widerstandsgebiet 200 geringfügig beeinflusst werden.

## Patentansprüche

1. Integrierter Schaltkreis mit
- einem vertikal integrierten Bipolartransistor und
- zumindest einem Emitterwiderstand, der mit einem Emitterhalbleitergebiet (300) des vertikal integrierten Bipolartransistors leitend verbunden ist,
wobei
- zumindest bereichsweise ein Kollektorhalbleitergebiet (50), ein Basishalbleitergebiet (400) und das Emitterhalbleitergebiet (300) vertikal übereinander angeordnet und monokristallin ausgebildet sind,
- ein Widerstandsgebiet (200) des Emitterwiderstandes über dem Emitterhalbleitergebiet (300) angeordnet und monokristallin ausgebildet ist, und
- das Widerstandsgebiet (200) zumindest bereichsweise einen größeren Schichtwiderstand als das Emitterhalbleitergebiet (300) aufweist.

2. Integrierter Schaltkreis nach Anspruch 1, **dadurch gekennzeichnet, dass** der Schichtwiderstand des Widerstandsgebiets (200) um zumindest den Faktor 10 größer ist als der Schichtwiderstand des Emitterhalbleitergebiets (300).

3. Integrierter Schaltkreis nach einem der vorhergehenden Ansprüche, **dadurch gekennzeichnet, dass** der Emitterwiderstand ein Dotierstoffkonzentrationsprofil aufweist, dass insbesondere mittels eines Verbindungsgebietes (220) einen niederohmigen Anschluss des Widerstandsgebiets (200) an das Emitterhalbleitergebiet (300) bewirkt.

4. Integrierter Schaltkreis nach einem der vorhergehenden Ansprüche, **dadurch gekennzeichnet, dass** das Widerstandgebiet (200) ein Siliziumkristall mit Kohlenstoff aufweist.

5. Integrierter Schaltkreis nach einem der vorhergehenden Ansprüche, **dadurch gekennzeichnet, dass** ein Gebiet (200, 210, 220) des Emitterwiderstandes einen Siliziumkristall mit Germanium aufweist.

6. Integrierter Schaltkreis nach einem der vorhergehenden Ansprüche, **dadurch gekennzeichnet, dass** das Widerstandgebiet (200) eine Dotierstoffkonzentration aufweist, die kleiner als eine Dotierstoffkonzentration im Emitterhalbleitergebiet (300) ist.

7. Integrierter Schaltkreis nach Anspruch 6, **dadurch gekennzeichnet, dass** die Dotierstoffkonzentration im Widerstandgebiet (200) kleiner ist als ein Zehntel der Dotierstoffkonzentration im Emitterhalbleitergebiet (300).

8. Integrierter Schaltkreis nach einem der vorhergehenden Ansprüche, **dadurch gekennzeichnet, dass** ein Anschlussgebiet (210) des Emitterwiderstandes ein hochdotiertes Halbleitergebiet aufweist.

9. Integrierter Schaltkreis nach einem der vorhergehenden Ansprüche, **dadurch gekennzeichnet, dass** ein Anschlussgebiet (210) des Emitterwiderstands eine Silizidschicht aufweist.

10. Integrierter Schaltkreis nach einem der vorhergehenden Ansprüche, **dadurch gekennzeichnet, dass der** Emitterwiderstand als Stromgegenkopplung verschaltet ist.

11. Integrierter Schaltkreis nach einem der vorhergehenden Ansprüchen, **gekennzeichnet durch** zumindest einem weiteren Bipolartransistor, dem zumindest ein weiterer Emitterwiderstand zugeordnet ist, wobei dieser Schichtwiderstand des weiteren Emitterwiderstands sich von dem anderen Schichtwiderstand signifikant unterscheidet.

12. Integrierter Schaltkreis nach einem der vorhergehenden Ansprüche, **dadurch gekennzeichnet, dass** eine Widerstandsgrundfläche des Emitterwiderstands innerhalb einer Transistorgrundfläche des Bipolartransistors auf dem Wafer liegt.

13. Verwendung eines integrierten Schaltkreises eines der vorhergehenden Ansprüche in einer Hochfrequenzvorrichtung, insbesondere in einem Radarsystem oder in einem Kommunikationssystem.

14. Verfahren zur Herstellung eines integrierten Schaltkreises, indem
- ein vertikal integrierter Bipolartransistor erzeugt wird und
- zumindest ein Emitterwiderstand erzeugt wird, der mit einem Emitterhalbleitergebiet (300) des vertikal integrierten Bipolartransistors leitend verbunden ist,
wobei
- zur Erzeugung des Emitterwiderstands ein Widerstandsgebiet (200) über dem Emitterhalbleitergebiet (300) monokristallin aufgebracht wird, indem Halbleitermaterial des Widerstandsgebiets (200) selektiv über das Emitterhalbleitergebiet (300) epitaktisch aufgebracht wird, und
- das Widerstandsgebiet (200) derart epitaktisch aufgebracht wird, dass der Schichtwiderstand des Widerstandsgebiets (200) größer ist als der Schichtwiderstand des Emitterhalbleitergebiets (300).

15. Verfahren, nach Anspruch 14, **dadurch gekennzeichnet, dass** das Widerstandgebiet (200) während der Epitaxie in situ mit einer kleineren Dotierstoffkonzentration als das Emitterhalbleitergebiet (300) zumindest bereichsweise dotiert wird.

16. Verfahren nach einem der Ansprüche 14 oder 15, **dadurch gekennzeichnet, dass** durch die Zugabe von GeH₄-Gas während der Epitaxie, Germaniumatome in ein Gebiet (200, 210, 220) des Emitterwiderstands eingebracht werden.

17. Verfahren nach einem der Ansprüche 14 bis 16, **dadurch gekennzeichnet, dass** durch die Zugabe von Methylsilan-Gas während der Epitaxie, Kohlenstoffatome in das Widerstandsgebiet (200) eingebracht werden.

## Geänderte Patentansprüche

### Geänderte Patentansprüche gemäss Regel 86(2) EPÜ.

**1.** Verfahren zur Herstellung eines integrierten Schaltkreises, indem *zur Erzeugung eines vertikalen integrierten Bipolartransistors*
- *ein Emitterfenster innerhalb von Dielektrikum (310, 320) erzeugt wird,*
- *ein monokristallines Emitterhalbleitergebiet (300) erzeugt wird,*
- zumindest ein Emitterwiderstand erzeugt wird, der mit einem Emitterhalbleitergebiet (300) des vertikal integrierten Bipolartransistors leitend verbunden ist,
- *wobei* zur Erzeugung des Emitterwiderstands ein Widerstandsgebiet (200) über dem Emitterhalbleitergebiet (300) monokristallin aufgebracht wird,
- indem *Halbleitermaterial des Widerstandsgebiets (200) im geöffneten Emitterfenster innerhalb des Dielektrikums (310, 320)* selektiv über das Emitterhalbleitergebiet (300) epitaktisch aufgebracht wird, und
- *indem das Widerstandsgebiet (200) mit einem größeren Schichtwiderstand als der Schichtwiderstand des Emitterhalbleitergebiets (300) aufgebracht wird.*

**2.** Verfahren, nach Anspruch 1, **dadurch gekennzeichnet, dass** das Widerstandgebiet (200) während der Epitaxie in situ mit einer kleineren Dotierstoffkonzentration als das Emitterhalbleitergebiet (300) zumindest bereichsweise dotiert wird.

**3.** Verfahren nach einem der Ansprüche 1 oder 2, **dadurch gekennzeichnet, dass** durch die Zugabe von GeH₄-Gas während der Epitaxie, Germaniumatome in ein Gebiet (200, 210, 220) des Emitterwiderstands eingebracht werden.

**4.** Verfahren nach einem der *vorhergehenden* Ansprüche, **dadurch gekennzeichnet, dass** durch die Zugabe von Methylsilan-Gas während der Epitaxie, Kohlenstoffatome in das Widerstandsgebiet (200) eingebracht werden.

**5.** *Verfahren nach einem der vorhergehenden Ansprüche, **dadurch gekennzeichnet, dass** mittels der selektiven Epitaxie das Kristallgitter des Emitterhalbleitergebiets (300) durch das Kristallgitter des Widerstandsgebiets (200) fortgesetzt wird.*

**6.** Integrierter Schaltkreis mit
- *einem Kollektorhalbleitergebiet (50), einem Basishalbleitergebiet (400) und einem Emitterhalbleitergebiet (300) eines vertikal integrierten Bipolartransistors und*
- zumindest einem Emitterwiderstand, der mit *dem* Emitterhalbleitergebiet (300) des vertikal integrierten Bipolartransistors leitend verbunden ist,
- *bei dem* zumindest bereichsweise das Kollektorhalbleitergebiet (50), das Basishalbleitergebiet (400) und das Emitterhalbleitergebiet (300) vertikal übereinander angeordnet und monokristallin ausgebildet sind,
- *bei dem* ein Widerstandsgebiet (200) des Emitterwiderstandes *innerhalb eines durch Dielektrikum (31, 320) gebildeten Emitterfensters* über dem Emitterhalbleitergebiet (300) angeordnet ist,
- *bei dem* das Widerstandsgebiet (200) monokristallin ausgebildet ist *und das Kristallgitter des Emitterhalbleitergebietes (300) fortsetzt,* und
- *bei dem* das Widerstandsgebiet (200) zumindest bereichsweise einen größeren Schichtwiderstand als das Emitterhalbleitergebiet (300) aufweist, *wobei das Widerstandgebiet (200) eine Dotierstoffkonzentration aufweist, die kleiner als eine Dotierstoffkonzentration im Emitterhalbleitergebiet (300) ist.*

**7.** Integrierter Schaltkreis nach Anspruch 1, **dadurch gekennzeichnet, dass** der Schichtwiderstand des Widerstandsgebiets (200) um zumindest den Faktor 10 größer ist als der Schichtwiderstand des Emitterhalbleitergebiets (300).

**8.** *Integrierter Schaltkreis nach einem der vorhergehenden Ansprüche, **dadurch gekennzeichnet, dass** der vertikale Bipolartransistor eine Vielzahl von Emitterfingern mit jeweils einem auf dem Emitterhalbleitergebiet (300) innerhalb des Emitterfensters angeordneten Widerstandsgebiets (200) aufweist.*

**9.** Integrierter Schaltkreis nach einem der vorhergehenden Ansprüche, **dadurch gekennzeichnet, dass** der Emitterwiderstand ein Dotierstoffkonzentrationsprofil aufweist.

**10.** *Integrierter Schaltkreis nach Anspruch 9, **dadurch gekennzeichnet, dass** ein Verbindungsgebiet (220) des Dotierstoffprofils einen niederohmigen Anschluss des Widerstandsgebiets (200) an das Emitterhalbleitergebiet (300) bewirkt.*

**11.** Integrierter Schaltkreis nach einem der vorhergehenden Ansprüche, **dadurch gekennzeichnet, dass** das Widerstandgebiet (200) ein Siliziumkristall mit Kohlenstoff aufweist.

**12.** Integrierter Schaltkreis nach einem der vorhergehenden Ansprüche, **dadurch gekennzeichnet, dass** ein Gebiet (200, 210, 220) des Emitterwiderstandes einen Siliziumkristall mit Germanium aufweist.

**13.** Integrierter Schaltkreis *nach einem der vorhergehenden Ansprüche,* **dadurch gekennzeichnet, dass** die Dotierstoffkonzentration im Widerstandgebiet (200) kleiner ist als ein Zehntel der Dotierstoffkonzentration im Emitterhalbleitergebiet (300).

**14.** Integrierter Schaltkreis nach einem der vorhergehenden Ansprüche, **dadurch gekennzeichnet, dass** ein Anschlussgebiet (210) des Emitterwiderstandes ein hochdotiertes Halbleitergebiet aufweist.

**15.** Integrierter Schaltkreis nach einem der vorhergehenden Ansprüche, **dadurch gekennzeichnet, dass** ein Anschlussgebiet (210) des Emitterwiderstands eine Silizidschicht aufweist.

**16.** Integrierter Schaltkreis nach einem der vorhergehenden Ansprüche, **dadurch gekennzeichnet, dass** der Emitterwiderstand als Stromgegenkopplung verschaltet ist.

**17.** Integrierter Schaltkreis nach einem der vorhergehenden Ansprüchen, **gekennzeichnet durch** zumindest einem weiteren Bipolartransistor, dem zumindest ein weiterer Emitterwiderstand zugeordnet ist, wobei dieser Schichtwiderstand des weiteren Emitterwiderstands sich von dem anderen Schichtwiderstand signifikant unterscheidet.

**18.** Integrierter Schaltkreis nach einem der vorhergehenden Ansprüche, **dadurch gekennzeichnet, dass** eine Widerstandsgrundfläche des Emitterwiderstands innerhalb einer Transistorgrundfläche des Bipolartransistors auf dem Wafer liegt.

**19.** Verwendung eines integrierten Schaltkreises eines der vorhergehenden Ansprüche in einer Hochfrequenzvorrichtung, insbesondere in einem Radarsystem oder in einem Kommunikationssystem.
